**Europäisches Patentamt**

**European Patent Office**

**Office européen des brevets**

(11) Veröffentlichungsnummer: **0 066 835**

**B1**

(12) **EUROPÄISCHE PATENTSCHRIFT**

(45) Veröffentlichungstag der Patentschrift:
18.05.88

(51) Int. Cl.⁴: **H 01 L 23/54**

(21) Anmeldenummer: **82104794.1**

(22) Anmeldetag: **01.06.82**

(54) Verfahren zur Kennzeichnung von Halbleiterchips und kennzeichenbarer Halbleiterchip.

(30) Priorität: **10.06.81 DE 3123031**

(43) Veröffentlichungstag der Anmeldung:
**15.12.82 Patentblatt 82/50**

(45) Bekanntmachung des Hinweises auf die Patenterteilung:
**18.05.88 Patentblatt 88/20**

(84) Benannte Vertragsstaaten:
**AT DE FR GB**

(56) Entgegenhaltungen:
**DE-A-2 642 770**
**DE-B-2 823 869**
**US-A-3 885 877**

**PATENTS ABSTRACTS OF JAPAN, Band 5 Nr. 63 (E-54) (735) 28 April 1981**

(73) Patentinhaber: **Siemens Aktiengesellschaft Berlin und München, Wittelsbacherplatz 2, D-8000 München 2 (DE)**

(72) Erfinder: **Schindlbeck, Günter, Dipl.- Ing., Habichtstrasse 1a, D-8000 München 82 (DE)**

## Beschreibung

Die Erfindung betrifft ein Verfahren zur Kennzeichnung von Halbleiterchips bezüglich mindestens eines bestimmten Merkmals mittels optisch erkennbarer, auf einer Oberfläche der Halbleiterchips angebrachter Markierungen.

Entsprechende Verfahren werden zur Kennzeichnung von Halbleiterchips angewandt, die in großer Anzahl aus einer Halbleiterscheibe ("wafer") hergestellt werden, nach Abschluß der Herstellungsprozesse geprüft und gemäß dem Prüfergebnis entsprechend vorgegebenen Qualitätsmerkmalen oder vorgegebenen Verwendungszwecken gekennzeichnet werden. So ist es beispielsweise üblich, integrierte Schaltkreise, wie z. B. Halbleiterspeicher, noch vor dem Zerteilen der Halbleiterscheiben durch Anlegen von Meßspitzen an auf der Chipoberfläche angeordneten Kontaktflächen mittels eines Testers zu prüfen und je nach Prüfresultat auf dem Bereich der Chipoberfläche, der keine Kontaktoberflächen aufweist, mit kleinen Tintenflecken zu versehen. Dieser Vorgang wird auch als "Inken" bezeichnet. Die Tintenflecke können unterschiedliche Farben aufweisen, so daß z. B. ein nicht geinkter Chip als der Qualitätsstufe 1 zugehörig, ein mit roter Tinte geinkter Chip als der Qualitätsstufe 2 zugehörig und ein mit blauer Tinte geinkter Chip als Ausschuß kennzeichenbar ist. Solche mehrfarbigen Inkverfahren haben den Nachteil, daß Tinte auf der Chipoberfläche, insbesondere im aktiven Bereich, ein Zuverlässigkeitsrisiko darstellt. Durch Ausgasen der Tinte können ferner Probleme bei der Chipmontage auftreten. Weiterhin treten gelegentlich bei Abnehmern von geinkten Systemen Bedenken auf, da mit solchen Tintenflecken versehene Chips leicht als zweitrangig eingestuft werden können.

Ein anderes Kennzeichnungsverfahren sieht eine Hardware-Scheibenkarte vor, die den zu prüfenden Chips auf der Halbleiterscheibe entsprechend gerastert ist. Entsprechend der Funktionsfähigkeit der einzelnen Chips können einzelne Raster ausgestanzt werden, so daß ein topographisches Bild der Halbleiterscheibe entsteht. Bei diesem Verfahren ist jedoch die Übertragung der Informationen der Hardware-Scheibenkarten bei der Chipmontage schwierig und aufwendig, ferner besteht die Gefahr der Verwechslung einzelner Scheibenkarten und somit die Gefahr von Ausbeuteverlusten. Anstelle der Hardware-Scheibenkarte ist es auch möglich, die entsprechenden Informationen auf eine Software-Scheibenkarte, beispielsweise auf ein Datenband, zu bringen und diese Software-Scheibenkarte zur Montagesteuerung zu verwenden. Der hierbei erforderliche hohe Automatisierungsgrad verursacht jedoch hohe Kosten, eine Verwechslungsgefahr der Chips bzw. der Scheiben ist trotzdem nicht ausgeschlossen.

Aus der DE-AS 28 23 869 ist eine Kennsymbol-Anreißvorrichtung bekannt zum Anbringen von Symbolen auf Wafern für Halbleitervorrichtungen und zur Kontrolle, ob die Symbole richtig angebracht sind. Die Symbole dienen jeweils der numerischen bzw. alphanumerischen Identifizierung eines gesamten Wafers. Als Symbole sind balkenförmige Codes verwendet. Das Aufbringen der Symbole erfolgt mittels einer Diamant- oder Laserschneidevorrichtung unter Anreißen bzw. Anritzen der Waferoberfläche. Die Vorrichtung ist außerdem eine zusätzliche Vorrichtung bei der Herstellung der Halbleitervorrichtungen. Aufgabe der vorliegenden Erfindung ist es, hier Abhilfe zu schaffen und ein Verfahren zur Kennzeichnung von Halbleiterchips vorzusehen, bei dem der einzelne Chip unverwechselbar gekennzeichnet ist und bei dem ein zusätzliches Zuverlässigkeitsrisiko und eine Minderung des Verkaufswertes nicht auftritt.

Diese Aufgabe wird bei einem Verfahren der eingangs genannten Art erfindungsgemäß dadurch gelöst, daß die optisch erkennbaren Markierungen durch Veränderung der Oberfläche mindestens eines, zum Zwecke des Markierens vorgesehenen, aus einem homogenen und gut reflektierenden Material bestehenden Flächenteils angebracht werden. Auf diese Weise gelingt es ohne Aufbringen eines zusätzlichen Stoffes auf die Chipoberfläche die Halbleiterchips zu kennzeichnen und die Kennzeichnung so zu gestalten, daß sie von einem Unbeteiligten nicht erkannt werden kann. Als zum Zwecke des Markierens vorgesehene Flächenteile werden vorzugsweise metallisierte Flächen oder aus polykristallinem Halbleitermaterial bestehende Flächen verwendet, da solche Flächen auch anderweitig bei der Herstellung von Integrierten Schaltungen vorgesehen sind und somit ohne nennenswerte Mehrkosten herstellbar sind.

Die optische Markierung kann vorteilhafterweise durch mechanischen Abdruck einer auf den zum Zwecke des Markierens vorgesehenen Flächenteils aufdrückbaren Spitze angebracht werden, da solche Spitzen, z. B. als Meßspitzen, beim Prüfungsverfahren bereits auf die dafür vorgesehenen Kontaktflächen zur Herstellung von Außenanschlüssen angelegt werden, und somit das erfindungsgemäße Verfahren ohne zusätzliche Vorrichtungen durchführbar ist.

Es liegt weiterhin im Rahmen der Erfindung, daß die optisch erkennbaren Markierungen auf der zum Zwecke des Markierens vorgesehenen Fläche durch Bestrahlung mittels eines Lasers angebracht wird.

Ein Halbleiterchip zur Durchführung des erfindungsgemäßen Verfahrens kann so ausgeführt sein, daß mindestens eine, einer Kontaktfläche entsprechend ausgeführte Metallfläche vorgesehen ist, auf der eine optisch erkennbare Markierung anbringbar ist.

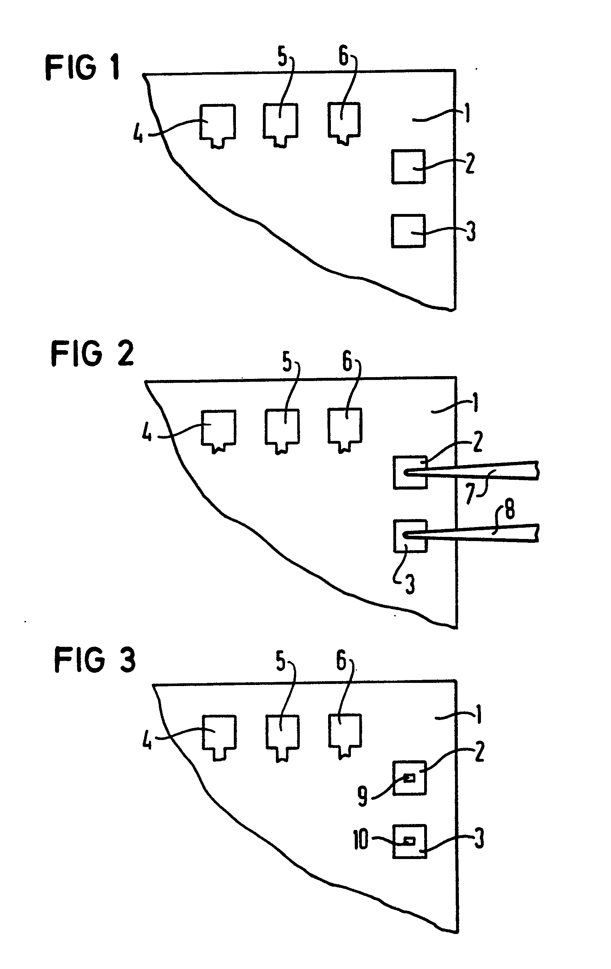

Die Erfindung wird im folgenden anhand der Figuren näher erläutert. Die Figuren 1 bis 3 zeigen die vergrößerte, ausschnittsweise dargestellte Oberfläche eines Halbleiterchips während unterschiedlicher Verfahrensstadien.

Der in Fig. 1 gezeigte vergrößerte Ausschnitt eines Halbleiterchips 1 in Draufsicht zeigt drei metallische Kontaktflächen 4, 5, 6, die zur Funktionsüberprüfung des Chips mit Prüfspitzen kontaktierbar sind und die bei der Montage des Chips mit einem mit den Außenanschlüssen des Bauelementgehäuses verbindbaren Draht kontaktiert werden. Weiterhin sind zwei weitere Kontaktflächen 2, 3 dargestellt, die zur Durchführung des erfindungsgemäßen Verfahrens vorgesehen sind und später nicht mittels eines Drahtes kontaktiert werden. Die Flächen 2 bis 6 sind beispielsweise als Aluminium hergestellt.

Nach der Funktionsprüfung des Chips 1 werden entsprechend der festgestellten Qualitätsstufe oder entsprechend dem gewünschten Verwendungszweck metallische Spitzen 7 und 8 auf die zum Zwecke der Markierung vorgesehenen Flächen 2 und 3 - wie in der Fig. 2 dargestellt - mechanisch aufgedrückt.

Nach Entfernung der Spitzen 7 und 8 - vgl. Fig. 3 - verbleiben auf den Flächen 2 und 3 Abdrücke 9 bzw. 10, deren Größe entsprechend der Größe der Enden der Spitzen 7 und 8 so gewählt ist, daß die Abdrücke unter einem ohnehin zur Montage der Chips verwendeten Mikroskop erkennbar sind. Die Qualitätsmerkmale können mittels zweier zum Zwecke des Markierens vorgesehener Flächen 2 und 3 beispielsweise in der Weise codiert werden, daß kein Abdruck auf den Flächen 2 und 3 einen Ausschuß-Chip, ein Abdruck 9 auf der Fläche 2, aber kein Abdruck auf der Fläche 3 einen Chip der Qualitätsstufe 1, ein Abdruck 10 auf der Fläche 3 und kein Abdruck auf der Fläche 2 einen Chip der Qualitätsstufe 2 und jeweils ein Abdruck 9, 10 auf der Fläche 2 und 3 einen Chip der Qualitätsstufe 3 kennzeichnen. Sollen mehr als vier Merkmale unterschieden werden, so können entsprechend mehr zum Zwecke der Markierung vorgesehene Flächen vorgesehen werden.

Die zur Kennzeichnung verwendeten Spitzen 7, 8 können entsprechend den üblicherweise verwendeten - z. B. aus der DE-OS 30 14 127 bekannten - Prüfspitzen aus Kupferberyllium, Wolfram-Karbid oder Wolfram hergestellt sein. Als zum Zwecke des Markierens vorgesehene Flächen 2, 3 eignen sich insbesondere in Dimension und technologischer Ausführung den Kontaktflächen 4, 5, 6 (Anschlußpads) entsprechend hergestellte Aluminiumflächen. Es können aber auch andere aus einem homogenen und gut reflektierenden Material bestehende Flächen verwendet werden, beispielsweise Flächen aus polykristallinem Halbleitermaterial. Eine Kennzeichnung an dafür nicht von vornherein vorgesehenen Flächen, beispielsweise einer von einem Oxid bedeckten Fläche, ist zu vermeiden, da sonst eine Zerstörung der Passivierung des Chips erfolgen kann. Die verwendeten Spitzen 7 und 8 sollten vorteilhafterweise einen Spitzendurchmesser im Bereich zwischen 10 und 200 μm aufweisen, während die zum Zwecke des Markierens vorgesehenen Flächen 2, 3 eine Breite im Bereich von 50 bis 500 μm aufweisen können.

**Patentansprüche**

1. Verfahren zur Kennzeichnung von Halbleiterchips (1) bezüglich mindestens eines bestimmten Merkmals mittels optisch erkennbarer, auf einer Oberfläche der Halbleiterchips (1) angebrachter Markierungen (9, 10), dadurch gekennzeichnet, daß die optisch erkennbaren Markierungen (9, 10) durch Veränderung der Oberfläche mindestens eines, zum Zwecke des Markierens vorgesehenen, aus einem homogenen und gut reflektierenden Material bestehenden Flächenteils (2) angebracht werden.

2. Verfahren nach Anspruch 1, dadurch gekennzeichnet, daß als zum Zwecke des Markierens vorgesehener Flächenteil (2) eine metallisierte Fläche verwendet wird.

3. Verfahren nach Anspruch 1, dadurch gekennzeichnet, daß als zum Zwecke des Markierens vorgesehener Flächenteil (2) eine aus polykristallinem Halbleitermaterial bestehende Fläche verwendet wird.

4. Verfahren nach einem der Ansprüche 1 bis 3, dadurch gekennzeichnet, daß die optisch erkennbare Markierung (9, 10) durch einen mechanischen Abdruck einer auf den zum Zwecke des Markierens vorgesehenen Flächenteil (2) aufdrückbaren Spitze (7) angebracht wird.

5. Verfahren nach einem der Ansprüche 1 bis 4, dadurch gekennzeichnet, daß die optisch erkennbare Markierung (9, 10) auf dem zum Zwecke des Markierens vorgesehenen Flächenteil (2) durch Bestrahlung mittels eines Lasers angebracht wird.

6. Halbleiterchip mit Kontaktflächen, die der elektrischen Kontaktierung des Halbleiterchips mit Draht dienen, zur Durchführung des Verfahrens nach einem der vorhergehenden Ansprüche, dadurch gekennzeichnet, daß zusätzlich zu den Kontaktflächen (4, 5, 6), mindestens ein Flächenteil (2, 3) aus homogenem und gut reflektierendem Material vorgesehen ist, das nicht der elektrischen Kontaktierung des Halbleiterchips (1) mit Draht dient und auf dem eine optisch erkennbare Markierung (9, 10) anbringbar ist.

**Claims**

1. A method of identifying semiconductor chips (1) in respect of at least one specified feature by means of optically detectable marks (9, 10) applied to a surface of the semiconductor chips (1), characterised in that the optically detectable marks (9, 10) are applied by changing the surface of at least one surface portion (2) which is provided for marking purposes and which consists of a homogeneous and highly reflective material.

2. A method as claimed in Claim 1, <u>characterised in that</u> a metallised surface area is used as the surface portion (2) provided for marking purposes.

3. A method as claimed in Claim 1, <u>characterised in that</u> a surface consisting of polycrystalline semiconductor material is used as the surface portion (2) provided for marking purposes.

4. A method as claimed in one of Claims 1 to 3, <u>characterised in that</u> the optically detectable mark (9, 10) is applied by the mechanical impression of a probe (7) which can be pressed on to the surface portion (2) provided for marking purposes.

5. A method as claimed in one of Claims 1 to 4, <u>characterised in that</u> the optically detectable mark (9, 10) is applied to the surface portion (2) provided for marking purposes, by irradiation using a laser.

6. A semiconductor chip, provided with contact surface areas which serve for the electrical contacting of the semiconductor chip with wires, for carrying out the method claimed in one of the preceding Claims, <u>characterised in that</u>, in addition to the contact surface areas (4, 5, 6), at least one surface area (2, 3) consisting of homogeneous and highly reflective material is provided which is not used to electrically contact the semiconductor chip (1) with wires and to which an optically detectable mark (9, 10) can be applied.

**Revendications**

1. Procédé pour marquer des puces semiconductrices (1) du point de vue d'au moins une caractéristique, à l'aide de repères (9, 10) marqués sur une surface de la puce semiconductrice (1) et susceptibles d'être identifiés par voie optique, caractérisé par le fait que les repères (9, 10) identifiables par voie optique sont réalisés par modification de la surface d'au moins un élément de surface (2) qui est prévu pour le marquage et qui est constitué par un matériau homogène et ayant de bonnes propriétés réfléchissantes.

2. Procédé selon la revendication 1, caractérisé par le fait que l'on utilise, comme élément de surface (2) prévu pour le marquage, une surface métallisée.

3. Procédé selon la revendication 1, caractérisé par le fait que l'on utilise, comme élément de surface (2) prévu pour le marquage, une surface constituée par un matériau semiconducteur polycristallin.

4. Procédé selon l'une des revendications 1 à 3, caractérisé par le fait que le repère (9, 10) identifiable par voie optique est réalisé par la reproduction mécanique d'une pointe (7) à appliquer sur l'élément de surface (2) prévu pour le marquage.

5. Procédé selon l'une des revendications 1 à 4, caractérisé par le fait que le repère (9, 10) identifiable par voie optique est réalisé sur l'élément de surface prévu pour le marquage, par irradiation à l'aide d'un laser.

6. Puce semiconductrice comportant des surfaces de contact qui servent à l'établissement des contacts électriques de la puce semiconductrice avec des fils, caractérisée par le fait qu'en plus des surfaces de contact (4, 5, 6), il est prévu au moins un élément de surface (2, 3) en un matériau homogène et possédant de bonnes propriétés réfléchissantes, ledit élément de surface ne servant pas à la réalisation des contacts électriques de la puce semiconductrice avec des fils, et sur lequel peut être réalisé le repère (9, 10) identifiable par voie optique.

**FIG 1**

**FIG 2**

**FIG 3**